# DEMANDE DE BREVET EUROPEEN

(11) **EP 2 093 578 A1**
(43) Date de publication de la demande: **26.08.2009**
(21) Numéro de dépôt: 09152773.9
(22) Date de dépôt: 13.02.2009
(51) Int. Cl.: G01R 31/26, H01L 31/042

(54) **Installation de modules photovoltaïques télécommandés**

(30) Priorité: 19.02.2008 FR 0800872
(71) Demandeur: Photowatt International, 38300 Bourgoin Jallieu (FR)
(72) Inventeur: Proisy, Bernard, 69360, SOLAIZE (FR); Dumas, Philippe, 38890, SAINT CHEF (FR); Aurousseau, Valery, 38080, L'ISLE D'ABEAU (FR)
(74) Mandataire: Verriest, Philippe

(57) **Abrégé**

L'invention concerne une installation (1) de modules photovoltaïques (3) comprenant un dispositif de «contrôle commande» (2), un ensemble de modules photovoltaïques (3), destinés à transformer l'énergie solaire en courant électrique, comprenant des bornes de puissance. Chaque module photovoltaïque (3) comprend un interrupteur contrôlant le passage d'un courant aux bornes de puissance, des moyens de commande conçus pour commander l'interrupteur (11), des moyens de communication (17) conçus pour permettre la communication entre les moyens de commande de l'interrupteur du module photovoltaïque (3) et le dispositif de «contrôle commande» (2) de l'installation (1). Chaque module photovoltaïque comprend en outre des moyens d'adressage conçus pour identifier de façon unique un module photovoltaïque (3) et/ou un groupe de modules photovoltaïques (3) et des moyens de mesure d'au moins un paramètre de fonctionnement du module photovoltaïque (3).

## Description

L'invention concerne une installation de modules de cellules photovoltaïques.

Il est à noter qu'un module de cellules photovoltaïques peut préférentiellement être appelé module photovoltaïque. Un ensemble plan de modules photovoltaïques contigus peut également être appelé panneau photovoltaïque. Il est à noter en outre qu'un ensemble de panneaux photovoltaïques peut préférentiellement être appelé champ solaire photovoltaïque lorsqu'il forme une unité de production d'électricité directement à partir du rayonnement solaire. De tels champs sont traditionnellement rencontrés sur des toitures, sur des terrasses ou encore implantés en pleine nature, par exemple avec un châssis en plein champ ou installé sur pylône.

Un module photovoltaïque permet de créer de l'énergie électrique à partir de l'énergie radiative du soleil et du phénomène de conversion photovoltaïque. Un module photovoltaïque est donc un générateur électrique qui génère une tension et fournit un courant lorsqu'il est soumis à un éclairement.

De façon connue, le module photovoltaïque, ou un ensemble de modules photovoltaïques, est relié à des moyens de stockage ou/et de distribution d'énergie électrique. En particulier, il est possible de le relier à une batterie de stockage en courant continu, ou au réseau de distribution, en courant alternatif.

Lorsqu'une défaillance se produit dans un tel générateur électrique, une opération de maintenance est nécessaire. Un opérateur doit déterminer dans un premier temps le module photovoltaïque défectueux en testant chacun des modules photovoltaïques. Pour effectuer cette opération, il doit accéder à l'ensemble des modules photovoltaïques dont l'accès est plus ou moins facilité suivant leur emplacement. Cet accès est d'autant plus difficile lorsque les modules photovoltaïques sont situés en hauteur, en particulier sur une toiture.

Après avoir déterminé le module défectueux, l'opérateur doit isoler le module photovoltaïque puisqu'il s'agit d'un générateur électrique. Il doit en outre isoler les moyens de stockage ou/et de distribution d'énergie électrique afin d'intervenir sur les générateurs hors tension afin d'éviter tout risque d'électrisation ou même d'électrocution.

Traditionnellement, toute autre source d'énergie est isolée facilement au moyen d'un disjoncteur par exemple ou d'un sectionneur en charge ou encore un interrupteur.

Cependant, un module photovoltaïque génère un courant continu qui présente l'inconvénient majeur d'être difficile à interrompre lorsque la tension est élevée. Pour contourner cette difficulté, il convient soit d'attendre la nuit, soit de couvrir les modules photovoltaïques, ce qui n'est pas simple. Il est possible d'avoir recours soit aux sectionneurs à ouverture brusque, ou d'utiliser des sectionneurs à soufflage magnétique, ces matériels étant très peu courants, soit d'utiliser la coupure statique.

L'invention vise à résoudre en tout ou partie ces inconvénients en proposant une installation permettant de réaliser sélectivement des opérations sur un module photovoltaïque ou un ensemble de modules photovoltaïque en nécessitant une modification limitée de l'installation.

A cet effet, l'invention consiste pour cela en une installation de modules photovoltaïques comprenant :
- un dispositif de contrôle commande,
- un ensemble de modules photovoltaïques, destinés à transformer l'énergie solaire en courant électrique, comprenant des bornes de puissance, chaque module photovoltaïque comprenant :
   o un interrupteur contrôlant le passage d'un courant aux bornes de puissance,
   o des moyens de commande conçus pour commander l'interrupteur,
   o des moyens de communication conçus pour permettre la communication entre les moyens de commande de l'interrupteur du module photovoltaïque et le dispositif de contrôle commande de l'installation,
   o des moyens d'adressage conçus pour identifier de façon unique un module photovoltaïque et/ou un groupe de modules photovoltaïques,
   o des moyens de mesure d'au moins un paramètre de fonctionnement du module photovoltaïque ou du groupe de modules photovoltaïques,
- des moyens de stockage et/ou des moyens de distribution d'énergie électrique, en particulier un circuit électrique tel qu'une batterie en courant continu ou un réseau de distribution d'électricité, relié aux bornes de puissance des modules photovoltaïques,
le dispositif de contrôle commande étant agencé pour collecter de façon sélective des paramètres de fonctionnement d'un module photovoltaïque ou un groupe de modules photovoltaïques, pour commander et/ou arrêter sélectivement un groupe de modules photovoltaïques.

Un tel dispositif présente l'avantage considérable de mettre sous tension ou hors tension un module photovoltaïque spécifique ou un ensemble de modules photovoltaïques sans avoir à subir des contraintes horaires, telles qu'attendre la nuit par exemple.

Grâce aux dispositions selon l'invention, il devient également possible de mettre le module photovoltaïque hors tension rendant ainsi le module photovoltaïque inutilisable en cas de vol frauduleux du module photovoltaïque, par une personne indélicate par exemple. Par conséquent, l'avantage de pouvoir rendre le module photovoltaïque non fonctionnel permet de décourager le vol.

De plus, une telle installation permet d'utiliser les moyens de communication pour transmettre des informations utiles à la maintenance ou à la gestion de l'énergie des bâtiments. En effet, pour la maintenance, il est possible, grâce aux dispositions selon l'invention, de vérifier le bon fonctionnement de chaque module photovoltaïque ou d'indiquer une anomalie. En particulier, pour la gestion de l'énergie des bâtiments, le dispositif de contrôle commande permet le regroupement des informations climatiques, telles que la température et l'humidité.

Selon une caractéristique de l'invention, une pluralité des modules photovoltaïques sont connectés en série.

La disposition en série des modules photovoltaïques génère une tension élevée en sortie du champ photovoltaïque formé par une pluralité de modules.

Selon une caractéristique de l'invention, les moyens de communication sont constitués par des moyens utilisant des courants porteurs en ligne ou des ondes hertziennes.

Ces caractéristiques offrent la possibilité de réaliser un diagnostic de l'état d'un module photovoltaïque ou d'un ensemble de modules photovoltaïques tout en offrant une installation qui ne nécessite pas de câblage de réseau additionnel pour les moyens de communication.

Avantageusement, le paramètre spécifique est un courant.

Préférentiellement, les moyens de commande sont disposés à l'intérieur de l'empilage laminé de verre, de cellules et de polymère du module photovoltaïque.

Selon une caractéristique de l'invention, les moyens d'adressage comprennent une adresse individuelle et une ou plusieurs adresses de groupe correspondant à un groupe de modules photovoltaïques ou l'ensemble des modules photovoltaïque du champ, conçus pour identifier de façon unique un module photovoltaïque ou un groupe de modules photovoltaïques.

Avantageusement, l'installation comprend des moyens de vérification de l'intégrité et/ou de l'authenticité d'un ordre de commande communiqué entre le poste de contrôle commande et un module photovoltaïque.

Préférentiellement, les moyens de vérification sont conçus pour utiliser un code d'accès transmis entre le poste de contrôle commande et un module photovoltaïque. Ce contrôle d'accès constitue une sorte de mot de passe.

Selon une caractéristique de l'invention, les moyens de vérification sont conçus pour utiliser un code de vérification de l'intégrité des messages. Préférentiellement le code de vérification de l'intégrité est réalisé par 'somme de contrôle à redondance cyclique' en complément au contrôle élémentaire de parité. Une 'checksum' à redondance cyclique ('CRC 16' par exemple) présente l'avantage d'avoir une très forte probabilité de détection d'erreur et même dans certains cas peut être utilisée pour reconstituer un message endommagé.

L'invention sera mieux comprise à l'aide de la description détaillée qui est exposée ci-dessous en regard du dessin annexé dans lequel :
La figure 1 est un schéma d'ensemble de l'installation selon l'invention.
La figure 2 est un schéma d'une portion de l'installation associée à un module photovoltaïque, utilisant un premier mode de communication.
La figure 3 est un schéma d'une portion de l'installation associée à un module photovoltaïque, utilisant un second mode de communication.
La figure 4 est un schéma représentant un module photovoltaïque.
La figure 5 est un schéma d'une trame de donnée.
La figure 6 est un organigramme des interactions entre le dispositif de contrôle commande et un module.

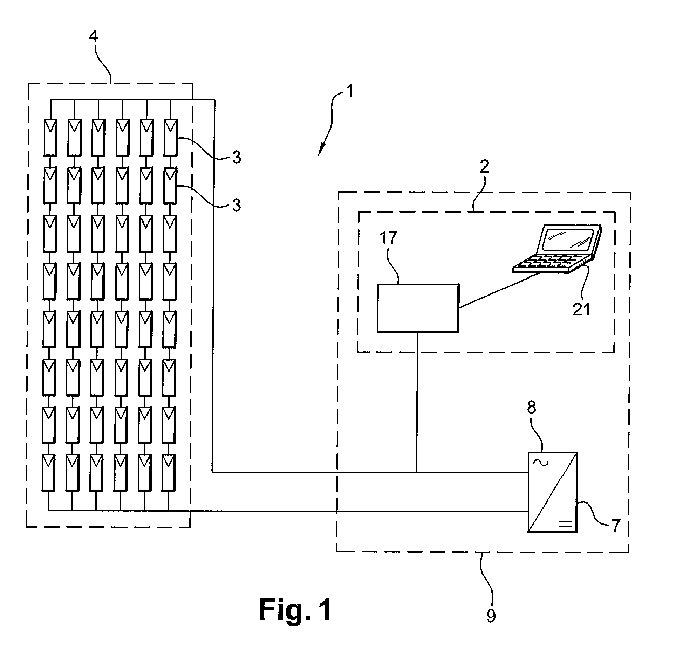

Selon un mode de réalisation tel que représenté à la figure 1, une installation 1 comprend un dispositif de contrôle commande 2 et un ensemble de modules photovoltaïques 3, appelé champ photovoltaïque 4, comprenant plusieurs rangées comportant chacune des modules photovoltaïques 3 connectés en série, chaque module photovoltaïque 3 comportant un ensemble de cellules photovoltaïques. Il est à noter que les modules photovoltaïques 3 peuvent être équipés de diodes by-pass, et en particulier de diodes Schottky, connectées en parallèle en vue d'éviter un échauffement trop important d'une (ou quelques) cellule d'un module photovoltaïque en cas d'ombrage. Une telle installation 1 est destinée à produire de l'énergie électrique, et en particulier un courant électrique, à partir de l'énergie solaire et de la conversion photovoltaïque.

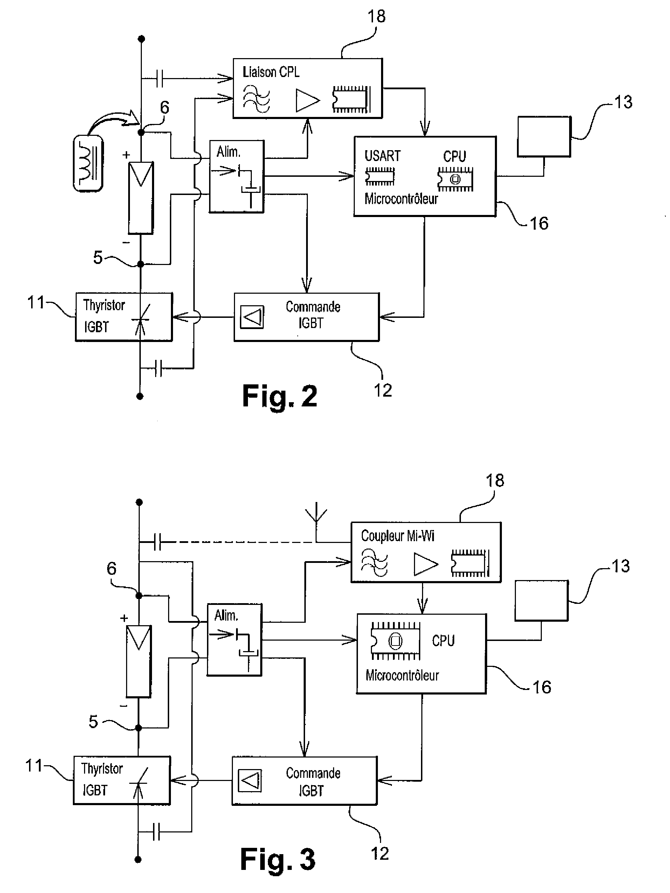

Chaque module photovoltaïque 3 comprend deux bornes de puissance, et en particulier une borne de puissance d'entrée 5 (-) et une borne de puissance de sortie 6 (+), comme représenté à la figure 2. Ces bornes de puissance 5, 6, sont conçues pour permettre la connexion de l'ensemble des modules photovoltaïques 3 vers des moyens de stockage 7 et/ou de distribution 8, en vue de récupérer l'énergie électrique ainsi produite qui est disponible aux bornes de puissance 5, 6 des modules photovoltaïques 3.

Les moyens de stockage 7 comprennent une batterie. La batterie est destinée à stocker l'énergie électrique produite par les modules photovoltaïques et à la restituer selon la demande.

Les moyens de distribution 8 comprennent un onduleur. Un onduleur est un appareil électronique permettant de transformer le courant continu de la batterie et/ou produit par les modules photovoltaïques 3, en courant alternatif. Plus précisément, l'onduleur convertit le courant continu en courant alternatif à 230 V, 50 Hz, qui est semblable à celui fourni par un réseau classique permettant ainsi d'utiliser, par exemple, des appareils en 230 V du commerce.

Les moyens de stockage 7 et/ou de distribution 8 sont regroupés dans un local technique 9 dans lequel est situé le dispositif de contrôle commande 2.

Comme représenté aux figures 2 et 3, un interrupteur 11 est associé à chaque module photovoltaïque 3. L'interrupteur 11 est positionné en série avec le module photovoltaïque. Plus précisément, il est placé en série avec la chaîne des cellules photovoltaïques entre les bornes de puissance du nouveau module photovoltaïque télécommandable. L'interrupteur peut être mis en place du côté négatif ou du côté positif du module photovoltaïques.

Cet interrupteur peut être un dispositif statique tel qu'un thyristor IGBT par exemple. D'autres dispositifs peuvent aussi être avantageusement retenus : transistor MOSFET, thyristor GTO, etc.

Le choix du côté de la coupure n'est dicté que par le côté pratique pour réaliser l'alimentation du dispositif, par contre la mise en place de l'interrupteur respecte impérativement le sens de parcourt du dispositif de coupure.

Il doit être bien compris que le choix de l'interrupteur 11 dépendra du critère d'optimisation retenu.

Le choix préférentiellement retenu sera soit un transistor à effet de champ réalisé selon la technologie MOSFET ou soit un thyristor IGBT ou GTO, qui présentent, par rapport à des transistors classiques, une grande simplicité de commande tout en conservant de faibles pertes par conduction. En particulier, l'interrupteur 11, représenté sur les figures 2 et 3, est un thyristor IGBT.

L'interrupteur 11 est destiné à contrôler le passage d'un courant entre les bornes de sorties de puissance du nouveau module photovoltaïque 3.

Le module photovoltaïque 3 comporte en outre des moyens de commande et de communication 12-16-18, alimentés, de préférence, par l'énergie électrique produite par le module photovoltaïque 3 lui-même. Ces moyens de commande 12 comprennent des moyens de commande de l'interrupteur 12a et un microcontrôleur 12b. Ils sont conçus pour commander l'interrupteur 11. Ils présentent, de préférence, une taille réduite afin de permettre leur disposition à l'intérieur d'un empilage laminé de verre et de polymère du module photovoltaïque 3. Cette caractéristique particulière est destinée à empêcher le contournement des moyens de commande 12 pour l'utilisation d'un module photovoltaïque 3 en cas de vol.

Des moyens de mesure 13 sont disposés au voisinage de chaque module photovoltaïque 3 ou situés préférentiellement au voisinage du capteur associé à la grandeur à mesurer. Les moyens de mesure 13 sont conçus pour mesurer une valeur 13a d'un paramètre spécifique. Plus précisément, les moyens de mesure 13 comprennent un capteur ou un ensemble de capteurs. Le paramètre spécifique mesuré est en particulier le courant qui circule dans les bornes de puissance 5, 6 d'un module photovoltaïque 3 et/ou la tension aux bornes de puissance 5, 6 d'un module photovoltaïque 3 et/ou une température et/ou d'autres paramètres de fonctionnement.

Chaque module photovoltaïque 3 comporte un premier mode de fonctionnement, dit mode normal, et un second mode de fonctionnement, dit mode télécommandé.

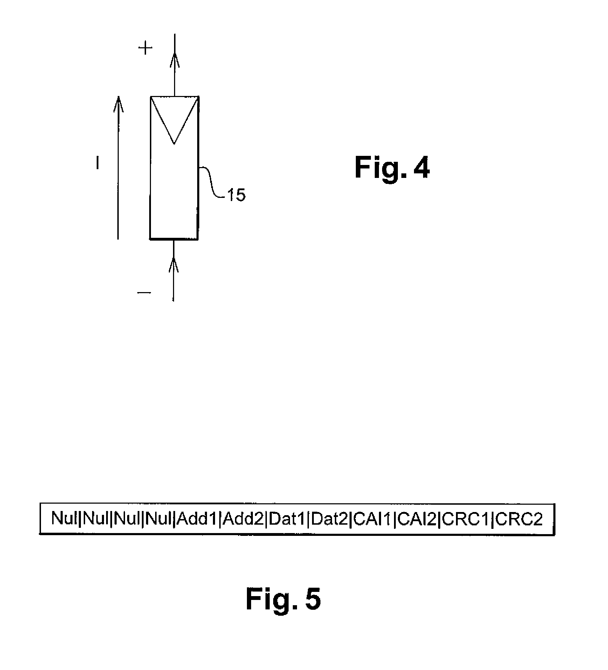

L'utilisation du mode télécommandé implique une programmation au préalable du module photovoltaïque 3. Il s'agit d'un paramétrage automatique au moment de la mise en service. Le mode télécommandé permet au module photovoltaïque 3 de recevoir un ordre de commande 14 en provenance du dispositif de contrôle commande 2, à l'aide du terminal 21, afin de réaliser une application spécifique. Le mode normal est le mode de fonctionnement du module photovoltaïque en sortie d'usine. Il permet au module photovoltaïque 3 de ne pas tenir compte d'un ordre de commande 14 reçu et de rester connecté en permanence à l'ensemble des modules photovoltaïques 3, comme un module photovoltaïque classique 15, tel que représenté à la figure 4.

Le microcontrôleur 16 comprend des moyens d'adressage. En particulier, les moyens d'adressage comprennent une adresse individuelle « Add1 » correspondant à l'adresse du module. Ils comprennent en outre une ou plusieurs adresses de groupe « Add2 » correspondant à des groupes de modules photovoltaïques 3.

Ils sont conçus pour identifier de façon unique un module photovoltaïque 3 et/ou un groupe de modules photovoltaïques 3. Ainsi, les moyens d'adressage permettent à partir du dispositif de contrôle commande 2 d'adresser un ordre de commande 14 vers un module photovoltaïque 3 spécifique ou vers un groupe de modules photovoltaïques 3 préalablement déterminé ou à l'ensemble que constitue le champ photovoltaïque 4. De plus, les moyens d'adressage permettent au dispositif de contrôle commande 2 de collecter de façon sélective la valeur « Dat. » des paramètres mesurés par les moyens de mesure 13 d'un module photovoltaïque 3 ou d'un groupe de modules photovoltaïques 3 ou de l'ensemble des modules 3 d'un champ photovoltaïque 4.

L'installation 1 comprend en outre des premiers et des seconds moyens de communication 17, 18 conçus pour permettre la communication entre le dispositif de contrôle commande 2 de l'installation 1 et le module photovoltaïque 3.

Selon un premier mode de réalisation tel que représenté à la figure 2, les moyens de communication 17, 18 sont mis en oeuvre en utilisant des courants porteurs en ligne.

Selon un second mode de réalisation tel que représenté à la figure 3, les moyens de communication 17, 18 sont mis en oeuvre en utilisant des ondes hertziennes. Les ondes hertziennes sont en particulier de type Wi-fi, Zig-bee, Mi-Wi, bluetooth ou autres.

Plus précisément, les moyens de communication 17, 18 sont destinés à permettre la communication des moyens de commande 12 de l'interrupteur 11 du module photovoltaïque 3 et/ou des moyens de mesure 13 avec le dispositif de contrôle commande 2. En particulier, les premiers moyens de communications 17 sont disposés au niveau du dispositif de contrôle commande 2 et les seconds moyens de communication 18 sont disposés au niveau de chaque module photovoltaïque 3. Les moyens de communication 17, 18 comprennent des moyens d'émission de données conçus pour envoyer des données émises sous forme de signal. Les moyens de communication 17, 18 comprennent en outre des moyens de réception de données conçus pour recevoir des données. En particulier, les données émises ou reçues sont un ordre de commande vers les modules 3 ou un paramètre mesuré ou un état de l'interrupteur en signalisation vers le dispositif de contrôle commande 2.

Pour pouvoir communiquer entre eux, le dispositif de contrôle commande 2 et les modules photovoltaïques 3, et en particulier leurs moyens de communication 17 et 18 utilisent un protocole spécifique.

Le protocole utilisé est un protocole à 7 niveaux (niveaux OSI de l'ISO, « Open System Inter-operability de l'International System Oganization). Ces niveaux décrivent précisément les règles à appliquer pour que les moyens de communication 17, 18 du dispositif de contrôle commande 2 et des modules photovoltaïques 3 puissent communiquer entre eux.

Une séquence du protocole est réalisée en utilisant une structure de trame de données telle que celle représentée pour l'exemple à la figure 5. Dans l'exemple montré la trame minima est réduite à 10 octets : une séquence de synchronisation d'ouverture (4 'Nul'), 2 champs d'adresses et données (Add-Dat), 1 champ de contrôle d'authenticité (Cal1) et 1 champ de contrôle de validité (Crc1 & Crc2). Le protocole indiqué dans l'exemple décrit à la figure 5 est réduit au plus court par rapport au besoin et comprend des données d'adressages, informations et contrôles : d'authenticité d'émission et de qualité de transmission.

Dans l'exemple indiqué pour information à la figure 5 les quatre premiers octets ne contiennent pas d'information et permettent d'éveiller les récepteurs. Le cinquième octet Add1 contient des informations concernant les moyens d'adressage 16. Le sixième octet Add2-Dat comprend quatre bits définis pour les groupes d'adresse et quatre bits qui codent l'ordre de commande 14 à envoyer. Il est à noter que la structure offre 16 possibilités pour les ordres de commande pouvant être exprimés. Les septième et huitième octets, respectivement CAI1 et CAI2, correspondent à des contrôles aléatoires d'initialisation, à savoir le code de contrôle et le code d'accès.

Les neuvième et dixième octets, respectivement CRC1 et CRC2, correspondent au contrôle par code à redondance cyclique.

Le dispositif de contrôle commande 2 comprend un poste de contrôle commande 21. Le poste de contrôle commande 21 est équipé d'une mémoire morte de type EEPROM. Une telle mémoire morte est conçue pour enregistrer des informations qui ne doivent pas être perdues lorsque l'appareil qui les contient n'est plus alimenté en électricité. En particulier, les adresses et les ordres de commande 14 sont enregistrés sur la mémoire morte.

Le dispositif de «contrôle commande» 2 permet, lorsque le module photovoltaïque 3 fonctionne en mode télécommandé, d'émettre un ordre de commande 14 par radiofréquence (Mi-Wi par exemple) ou courant porteur en ligne (CPL) afin de commander les moyens de commande 12. Le poste de «contrôle commande» 21 est une interface entre un utilisateur et le module photovoltaïque 3. Lorsque le module photovoltaïque 3 est en mode télécommandé, le poste de «contrôle commande» 21 permet en outre de comparer une valeur 13a mesurée par les moyens de mesure 13 par rapport à une valeur prédéterminée ou programmée par un utilisateur. Suivant sa programmation, le poste de «contrôle commande» 21 émet un ordre de commande 14 spécifique en fonction de la valeur 13a mesurée.

L'installation 1 comporte en outre des moyens de vérification de l'intégrité d'un ordre de commande 14 envoyé à un module photovoltaïque 3. Ces moyens de vérification sont enregistrés dans une mémoire morte. Ils sont destinés à sécuriser les moyens de communication 17, 18 entre le dispositif de «contrôle commande» 2 et le module photovoltaïque 3. En effet, ils permettent de vérifier le droit d'accès à la commande d'un module photovoltaïque 3.

Plus précisément, les moyens de vérification utilisent un code d'accès 22. Le code d'accès 22 est un code aléatoire généré au moyen d'un générateur de code d'accès 22 agencé dans le dispositif de «contrôle commande» 2. Le code aléatoire est, en particulier un nombre qui est stocké dans le poste de «contrôle commande» 21. Le code d'accès 22 est généré au moment de l'initialisation d'un site. Il est créé sur demande et automatiquement par le poste de «contrôle commande» 21. Lors de l'initialisation, le code d'accès 22 est communiqué au module photovoltaïque 3 par les moyens d'adressage 16 en établissant une connexion spécifique entre le module photovoltaïque 3 et le poste de «contrôle commande» 21. Ce code d'accès 22 est conçu pour permettre de valider l'autorisation d'exécuter un ordre de commande 14.

Les moyens de vérification utilisent en outre un code de vérification 23, de préférence de type cyclique par redondance, dit CRC, ou de type aléatoire appairé. Un tel code de vérification 23 est destiné à vérifier l'intégrité des ordres de commande 14 mis en oeuvre par le dispositif de «contrôle commande» 2 vers le module photovoltaïque 3.

La mise en place de l'installation 1 sur un site est opérée de la manière suivante.

En sortie d'usine, le module photovoltaïque 3 est en mode normal. Par conséquent, il ne peut exécuter un ordre de commande 14 et les moyens d'adressage 16 ne fonctionnent pas.

Une fois installé sur le site, chaque module photovoltaïque 3 est initialisé et programmé au moyen du poste de «contrôle commande» 21 afin de passer en mode télécommandé. Cette étape permet de programmer les modules photovoltaïques 3 pour une application spécifique.

L'initialisation d'un module photovoltaïque 3 est réalisée au moyen d'une connexion spécifique avec le poste de «contrôle commande» 21 du dispositif 2. A cet effet, un ordre d'écriture comprenant l'adresse individuelle du module photovoltaïque, les adresses de groupes définis par l'utilisateur au préalable, le code d'accès 22 et le code de contrôle 23, est transmis au module photovoltaïque 3.

Le module photovoltaïque 3 reçoit et enregistre son adresse individuelle et autant d'adresses que nécessaire pour fonctionner avec d'autres modules photovoltaïques 3 pour former des groupes de modules photovoltaïques 3.

Les moyens d'adressage 16 vont permettre la mise en oeuvre des moyens de communication 17, 18 entre le poste de «contrôle commande» 21 et un module photovoltaïque 3 ou un groupe de modules photovoltaïques 3 ou l'ensemble des modules photovoltaïques 3.

Une fois le module photovoltaïque 3 initialisé, il peut fonctionner en mode télécommandé.

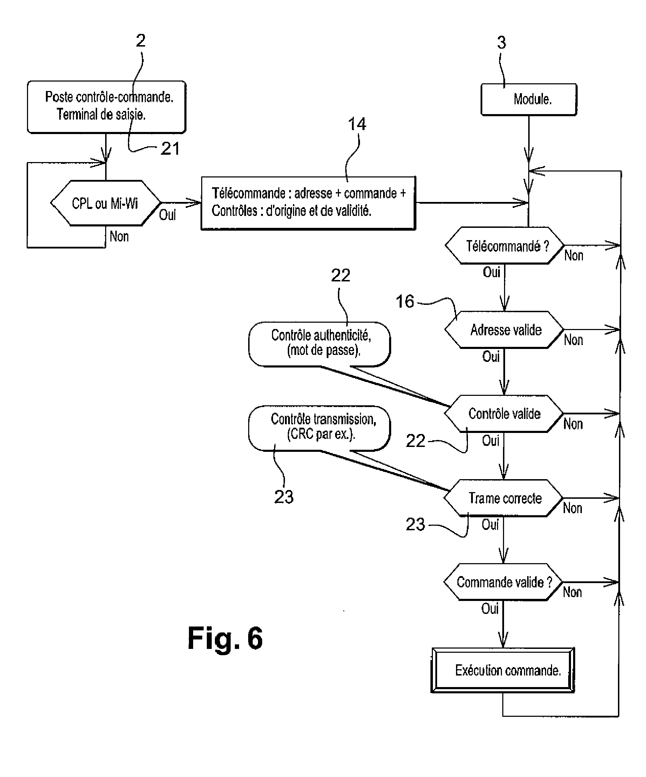

A cet effet, le dispositif de «contrôle commande» 2 envoie un ordre de commande 14, comme représenté à la figure 6. Lorsque le module photovoltaïque 3 reçoit un ordre de commande 14 à son adresse individuelle, le module photovoltaïque 3 vérifie dans un premier temps s'il s'agit d'une commande valide.

Un ordre de commande 14 est valide lorsque deux conditions sont réunies. D'une part, le code d'accès 22 émis par le poste de «contrôle commande» 21 et reçu par le module photovoltaïque 3, doit correspondre à celui mémorisé dans le module photovoltaïque 3 au moment de l'initialisation de l'installation sur un site. D'autre part, la vérification de la somme du code cyclique de vérification 23 CRC doit indiquer que le message reçu semble correct.

Dans un second temps, le module photovoltaïque 3 vérifie que l'ordre de commande 14 lui est adressé grâce aux moyens d'adressage 16. Il vérifie que l'adresse associée à l'ordre de commande 14 correspond à une des adresses qu'il a enregistrées au préalable lors de sa programmation.

Ainsi, lorsque le code d'accès 22 est valide et que l'ordre de commande 14 est adressé à un module photovoltaïque 3 déterminé, une connexion 24 est établie entre le poste de «contrôle commande» 21 et le module photovoltaïque 3 et le module photovoltaïque 3 déterminé exécute l'ordre de commande 14.

Cet ordre de commande 14 est, par exemple, la fermeture de l'interrupteur 11. Un tel ordre de commande 14 autorise le passage du courant. Cette commande est mémorisée par le module photovoltaïque 3.

Lorsque le module photovoltaïque 3 ne génère plus de tension pendant un temps déterminé au préalable lors de la programmation du module photovoltaïque 3, il se déconnecte. Ce phénomène se produit lorsque la lumière disparaît à la tombée de la nuit. Le module photovoltaïque 3 est alors réinitialisé. Une connexion est de nouveau établie lorsque le module photovoltaïque 3 donne à nouveau une tension et qu'il reçoit un ordre de commande 14 valide de re-connexion transmis périodiquement par le poste de «contrôle commande» 21 situé dans le local technique 9 qui, de préférence, est protégé par une serrure.

Il est à noter que dans le cas d'un changement de site d'installation ou d'utilisation, le changement d'affectation d'un module photovoltaïque 3 se fait en passant en mode normal. A cet effet, il reçoit un ordre d'écriture qui doit être valide pour être exécuté. Ainsi, lorsque le module photovoltaïque 3 est repassé en mode normal, il peut être reprogrammé en vue d'une nouvelle application.

Il est à noter en outre qu'un module photovoltaïque 3 qui a déjà été initialisé en mode télécommandé dans le passé, peut être initialisé à nouveau en utilisant le code d'accès 22 contenu précédemment dans le module photovoltaïque. Enfin, dans le cas où l'utilisateur du dispositif de «contrôle commande» 2 perd par inadvertance le code d'accès 22, un retour en usine des modules photovoltaïques 3 est alors nécessaire afin de les reprogrammer pour qu'ils fonctionnent en mode normal. En effet, l'utilisation d'une procédure sécurisée est nécessaire dans ce cas.

Bien que l'invention ait été décrite en liaison avec des exemples particuliers de réalisation, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Installation (1) de modules photovoltaïques (3) comprenant
- un dispositif de contrôle commande (2),
- un ensemble de modules photovoltaïques (3), destinés à transformer l'énergie solaire en courant électrique, comprenant des bornes de puissance (5, 6), chaque module photovoltaïque (3) comprenant :
o un interrupteur (11) contrôlant le passage d'un courant aux bornes de puissance (5, 6),
o des moyens de commande (12) conçus pour commander l'interrupteur (11),
o des moyens de communication (17, 18) conçus pour permettre la communication entre les moyens de commande (12) de l'interrupteur (11) du module photovoltaïque (3) et le dispositif de contrôle commande (2) de l'installation (1),
o des moyens d'adressage (16) conçus pour identifier de façon unique un module photovoltaïque (3) et/ou un groupe de modules photovoltaïques (3),
o des moyens de mesure (13) d'au moins un paramètre de fonctionnement du module photovoltaïque (3) ou du groupe de modules photovoltaïques,
- des moyens de stockage (7) et/ou des moyens de distribution (8) d'énergie électrique, en particulier un circuit électrique tel qu'une batterie en courant continu ou un réseau de distribution d'électricité, relié aux bornes de puissance (5, 6) des modules photovoltaïques (3),
le dispositif de contrôle commande (2) étant agencée pour collecter de façon sélective des paramètres de fonctionnement d'un module photovoltaïque (3) ou un groupe de modules photovoltaïques (3), pour commander et/ou arrêter sélectivement un groupe de modules photovoltaïques (3).

2. Installation (1) selon la revendication 1, dans laquelle une pluralité des modules photovoltaïques sont connectés en série.

3. Installation (1) selon l'une des quelconques revendications précédentes, dans laquelle les moyens de communication sont constitués par des moyens utilisant des courants porteurs en ligne ou des ondes hertziennes.

4. Installation (1) selon l'une des quelconques revendications précédentes, dans laquelle le paramètre spécifique est un courant.

5. Installation selon l'une des quelconques revendications précédentes, dans laquelle les moyens de commande (12) sont disposés à l'intérieur d'un empilage laminé de verre et de polymère.

6. Installation (1) selon l'une des quelconques revendications précédentes, dans laquelle les moyens d'adressage (16) comprennent une adresse individuelle et une ou plusieurs adresses de groupe correspondant à un groupe de modules photovoltaïques (3) ou l'ensemble des modules photovoltaïque (3) du champ (4), conçus pour identifier de façon unique un module photovoltaïque (3) ou un groupe de modules photovoltaïques (3).

7. Installation (1) selon l'une des quelconques revendications précédentes, comprenant des moyens de vérification (22, 23) de l'intégrité et/ou de l'authenticité d'un ordre de commande (14) communiqué entre le poste de contrôle commande (21) et un module photovoltaïque (3).

8. Installation (1) selon la revendication 7, dans laquelle les moyens de vérification (22, 23) sont conçus pour utiliser un code d'accès (22) transmis entre le poste de contrôle commande (21) et un module photovoltaïque (3).

9. Installation (1) selon l'une des quelconques revendications 7 ou 8, dans laquelle les moyens de vérification (22, 23) sont conçus pour utiliser un code de vérification (23).
